# EUROPÄISCHE PATENTSCHRIFT

(11) **EP 1 518 277 B1**
(45) Veröffentlichungstag und Bekanntmachung des Hinweises auf die Patenterteilung: **11.04.2007**
(21) Anmeldenummer: 03761415.3
(22) Anmeldetag: 12.06.2003
(51) Int. Cl.: H01L 27/115, H01L 21/8247

(54) **VERFAHREN ZUR HERSTELLUNG EINES NROM-SPEICHERZELLENFELDES**
METHOD FOR THE PRODUCTION OF AN NROM MEMORY CELL FIELD
PROCEDE POUR PRODUIRE UN CHAMP DE CELLULE MEMOIRE NROM

(30) Priorität: 28.06.2002 DE 10229065
(43) Veröffentlichungstag der Anmeldung: 30.03.2005
(73) Patentinhaber: Qimonda AG, 81739 München (DE); Qimonda Flash GmbH, 01099 Dresden (DE)
(72) Erfinder: DEPPE, Joachim, 01465 Dresden, OT Langebrück (DE); KLEINT, Christoph, 01324 Dresden (DE); LUDWIG, Christoph, 01465 Langebrück (DE); WILLER, Josef, 85521 Riemerling (DE)
(74) Vertreter: Epping - Hermann - Fischer
(86) Internationale Anmeldenummer: PCT/DE2003/001965
(87) Internationale Veröffentlichungsnummer: WO 2004/003979

(56) Entgegenhaltungen:
- WO-A-02/15276
- US-A- 5 972 747
- US-A- 6 025 626
- US-A1- 2003 006 428
- US-B1- 6 349 052

## Beschreibung

Die Erfindung betrifft den Bereich der elektrisch beschreib- und löschbaren Non-volatile-Flash-Memories. Sie gibt ein Verfahren zur Herstellung eines NROM-Speichers mit einer Anordnung von mit einer Oxid-Nitrid-Oxid-Speicherschicht aufgebauten nichtflüchtigen Speicherzellen an, die in einer Virtual-Ground-NOR-Architektur eingesetzt werden kann.

Kleinste nichtflüchtige Speicherzellen werden für höchste Integrationsdichte bei Multimedia-Anwendungen benötigt. Die Weiterentwicklung der Halbleitertechnik ermöglicht zunehmend größere Speicherkapazitäten, die sehr bald den Gigabitbereich erschließen werden. Während jedoch die von der Lithographie bestimmte minimale Strukturgröße weiterhin abnimmt, können andere Parameter, wie z. B. die Dicke des Tunneloxids nicht mehr entsprechend skaliert werden. Die bei planaren Transistoren mit der Strukturverkleinerung einhergehende Abnahme der Kanallänge erfordert eine Erhöhung der Kanaldotierung, um das Auftreten eines als Punch-through bezeichneten Spannungsdurchbruchs zwischen Source und Drain zu vermeiden. Das führt zu einer Erhöhung der Einsatzspannung, die üblicherweise mit einer Reduktion der Dicke des Gateoxids kompensiert wird.

Durch Channel-hot-Electrons programmierbare, mit Hot-Holes löschbare planare SONOS-Speicherzellen (s. Boaz Eitan US 5,768,192, US 6,011,725, WO 99/60631) erfordern jedoch ein Steuer-Dielektrikum mit einer einem Gate-Oxid gleichwertigen Dicke. Diese Dicke kann aber nicht beliebig vermindert werden, ohne dass die Anzahl der ausführbaren Programmierzyklen ("Endurance" der Speicherzelle) in nicht zu tolerierender Weise abnimmt. Erforderlich ist deshalb eine hinreichend große Kanallänge, damit die Dotierstoffkonzentration im Kanal nicht zu hoch gewählt werden muss, weil sonst die Einsatzspannung zu sehr ansteigt.

In der Veröffentlichung von J. Tanaka et al.: "A Sub-0.1-µm Grooved Gate MOSFET with High Immunity to Short-Channel Effects" in IEDM 93, S. 537 - 540 (1993) ist ein Transistor auf einem p⁺-Substrat beschrieben, bei dem die Gate-Elektrode in einem Graben zwischen dem n⁺-Source-Bereich und dem n⁺-Drain-Bereich angeordnet ist und so ein gekrümmter Kanal-Bereich in dem Substrat ausgebildet ist.

In der Veröffentlichung von K. Nakagawa et al.: "A Flash EE-PROM Cell with Self-Aligned Trench Transistor & Isolation Structure" in 2000 IEEE Symposium on VLSI Technology Digest of Technical Papers ist ein Transistor als Speicherzelle mit einer Floating-gate-Elektrode beschrieben, die zwischen dem n⁺-Source-Bereich und dem n⁺-Drain-Bereich bis in eine p-Wanne des Substrates reichend angeordnet ist. Zwischen der Floating-gate-Elektrode und der Kontroll-gate-Elektrode befindet sich eine Dielektrikumschicht aus einer Oxid-Nitrid-Oxid-Schichtfolge.

In der später veröffentlichten DE 101 29 958 ist eine Speicherzellenanordnung beschrieben, die mit niederohmigen Bitleitungen versehen ist. Auf dotierten Source-/Drain-Bereichen von Speichertransistoren ist eine entsprechend den Bitleitungen streifenförmig strukturierte gesonderte Schicht oder Schichtfolge angeordnet, die, insbesondere als Metallisierung, elektrisch leitend mit den Source-/Drain-Bereichen verbunden ist und den ohmschen Widerstand der Bitleitungen reduziert. Diese Schicht oder Schichtfolge umfasst insbesondere mindestens ein Material aus der Gruppe von dotiertem Polysilizium, Wolfram, Wolframsilicid, Kobalt, Kobaltsilicid, Titan und Titansilicid.

In der US 6 025 626 wird ein anderes NROM Speicherzellenfeld beschrieben. Auf diesem Dokument fußt die zweiteilige Untergliederung des Anspruches 1.

Wenn die Source-/Drain-Bereiche in Silizium ausgebildet werden, kann die Metallisierung der Bitleitungen eine silizierte Metallschicht sein, die nach dem Verfahren hergestellt wird, das unter der Bezeichnung "Salicide" als Abkürzung von Self-Aligned-Silicide bekannt ist. Bei anderen Ausführungsformen, bevorzugt ebenfalls auf Silizium, ist eine als Metallisierung aufgebrachte Schichtfolge aus Polysilizium und WSi bzw. WN/W sowie eine abdeckende und elektrisch isolierende Schicht aus einem für eine Hartmaske geeigneten Material, zum Beispiel einem Oxid oder Nitrid, auf den Source-/Drain-Bereichen der Speichertransistoren vorhanden. Die Metallisierungen der Bitleitungsstrukturen sind direkt auf dem Substrat und nach Bedarf teilweise über oxidbedeckten Bereichen strukturiert.

Die Source-/Drain-Bereiche der einzelnen Speichertransistoren werden mit einer Source-/Drain-Implantation hoher Dosis oder durch eine Ausdiffusion von Dotierstoff aus einer geeigneten Schicht, z. B. aus Polysilizium, hergestellt. Mit den auf den Source-/Drain-Bereichen aufgebrachten streifenförmigen Metallisierungen sind die Bitleitungen gebildet, die wegen der guten Leitfähigkeit der Metallisierungen einen besonders niedrigen ohmschen Widerstand aufweisen. Unter einer Metallisierung ist hier eine metallhaltige Schicht oder eine zumindest metallartige Eigenschaften aufweisende Leiterbahn zu verstehen. Die Source-/Drain-Bereiche derselben Bitleitung brauchen nicht bereits im Halbleitermaterial elektrisch leitend miteinander verbunden zu sein. Vorzugsweise jedoch sind die Bitleitungen als vergrabene Bitleitungen mit streifenförmigen dotierten Bereichen im Halbleitermaterial ausgebildet, die zusätzlich mit den Metallisierungen versehen sind.

Die Bitleitungsstrukturen sind auf der von dem Halbleitermaterial abgewandten Oberseite vorzugsweise in Nitridschichten gekapselt, die als Streifen ausgeführt werden und im Herstellungsverfahren als Ätzmaske zur Erzeugung dazu selbstjustierter Kanalbereiche der Transistoren dienen. Nach dem Aufbringen einer Speicherschicht, die vorzugsweise eine aus einer Begrenzungsschicht, einer eigentlichen Speicherschicht und einer weiteren Begrenzungsschicht gebildeten Schichtfolge besteht, die nach Art einer ONO-Schicht ausgebildet ist, wird eine Schichtfolge zur Herstellung von Wortleitungen abgeschieden und vorzugsweise durch eine Trockenätzung streifenförmig strukturiert.

Die Begrenzungsschichten sind Material einer höheren Energiebandlücke als die Energiebandlücke der Speicherschicht, so dass die Ladungsträger, die in der Speicherschicht eingefangen sind, dort lokalisiert bleiben. Als Material für die Speicherschicht kommt vorzugsweise ein Nitrid in Frage; als umgebendes Material ist vorrangig ein Oxid geeignet. Bei einer Speicherzelle im Materialsystem von Silizium ist die Speicherschicht in dem Beispiel einer ONO-Schichtfolge Siliziumnitrid mit einer Energiebandlücke von etwa 5 eV; die umgebenden Begrenzungsschichten sind Siliziumoxid mit einer Energiebandlücke von etwa 9 eV. Die Speicherschicht kann ein anderes Material sein, dessen Energiebandlücke kleiner als die Energiebandlücke der Begrenzungsschichten ist, wobei die Differenz der Energiebandlücken für einen guten elektrischen Einschluss der Ladungsträger (confinement) möglichst groß sein soll. In Verbindung mit Siliziumoxid als Begrenzungsschichten kann z. B. Tantaloxid, Hafniumsilicat, Titanoxid (im Fall stöchiometrischer Zusammensetzung TiO₂), Zirkonoxid (im Fall stöchiometrischer Zusammensetzung ZrO₂), Aluminiumoxid (im Fall stöchiometrischer Zusammensetzung Al₂O₃) oder intrinsisch leitendes (undotiertes) Silizium als Material der Speicherschicht eingesetzt werden.

Zwischen den Kanalbereichen der Transistoren benachbarter Speicherzellen kann durch eine Implantation von Dotierstoff mit variablem Einfallswinkel eine elektrische Isolation erzeugt werden, um die Transistoren voneinander zu isolieren, eine so genannte Anti-Punch-Implantation. Eine alternative Ausgestaltung sieht vor, diese Isolation durch Aussparungen, die mit Oxid gefüllt sind, zu realisieren; das geschieht nach Art einer STI (shallow trench isolation).

In der Figur 0 ist eine Anordnung aus Wortleitungen WLₙ₋₁, WLₙ, WLₙ₊₁ und Bitleitungen BLᵢ₋₁, BLᵢ, BLᵢ₊₁ in einer Aufsicht im Schema dargestellt. Die Bitleitungen sind hier als vergrabene Bitleitungen vorhanden und mit gestrichelten Linien als verdeckte Konturen eingezeichnet. Die Wortleitungen sind als vorzugsweise metallische Leiterbahnen auf der Oberseite der Anordnung angebracht. In einer jeweiligen Kreuzungsposition eines Aitleitungszwischengebiets und einer Wortleitung ist eine Speicherzelle des Speichers angeordnet (Crosspoint-Zelle). Die jeweils auszulesende oder zu programmierende Speicherzelle wird über die Bitleitungen und Wortleitungen in der an sich bekannten Weise adressiert. Die Gesamtheit der Speicherzellen mit den dargestellten Verbindungen durch Bitleitungen und Wortleitungen bilden einen Speicher in Virtual-Ground-NOR-Architektur.

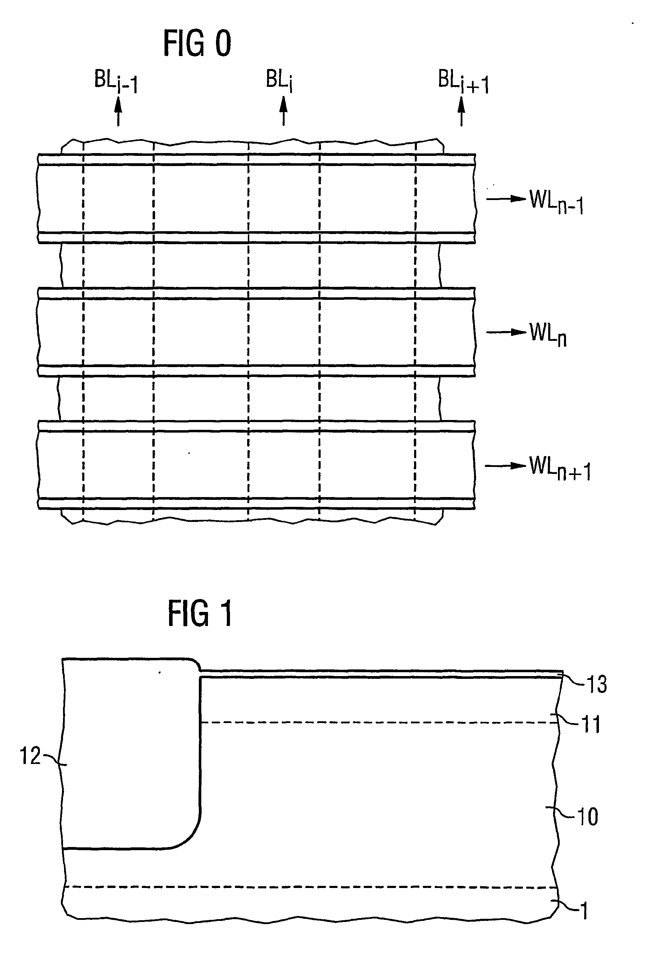

In der Figur 1 ist ein erstes Zwischenprodukt der Herstellung eines solchen Speichers in einem Querschnitt dargestellt. Es ist üblich, die Oberseite des Halbleitermateriales eines verwendeten Halbleiterkörpers 1, z. B. eines Substrates aus Silizium, oder einer auf einem Substrat aufgewachsenen Halbleiterschicht oder Halbleiterschichtfolge zunächst mit einem so genannten Pad-Oxid (Streuoxid) und Pad-Nitrid zu bedecken. Es werden Gräben in das Halbleitermaterial geätzt, die mit einem Oxid als STI (shallow trench isolation) aufgefüllt werden und zur Begrenzung des Speicherzellenfeldes (Randisolation 12) oder einzelner Speicherblöcke und gegebenenfalls zur Isolierung zwischen den Speicherzellen vorgesehen sind. Nach dem Planarisieren wird das Pad-Nitrid durch eine Ätzung entfernt. p-Wannen und n-Wannen, d. h. dotierte Bereiche, die tief in das Halbleitermaterial hinein reichen und für die Ansteuerperipherie und die Speicherzellen vorgesehen sind, werden bei Verwendung von Silizium als Halbleitermaterial vorzugsweise durch maskierte Bor-Implantationen und Phosphor-Implantationen mit anschließender Ausheilung der Implantate hergestellt. In der Figur 1 ist eine in dem Halbleiterkörper 1 ausgebildete p-Wanne 10.

Nach dem Entfernen des anfänglich aufgebrachten Pad-Oxids wird eine Oxidschicht 13 geeigneter Dicke aufgewachsen, die später außerhalb des Speicherzellenfeldes als Ätzstoppschicht dient. Bei diesem Herstellungsprozess wird dann mittels einer geeigneten Fototechnik eine Implantation (z. B. Phosphor) eingebracht, mit der ein hoch n-leitend dotierter Bereich 11 (n⁺-Bereich) in einem oberen Anteil der p-Wanne 10 ausgebildet wird, der für die später herzustellenden Source-/Drain-Bereiche vorgesehen ist. Die Vorzeichen der Dotierungen können auch vertauscht sein (p⁺-Bereich in einer n-Wanne). Im Bereich des Speicherzellenfeldes wird vorzugsweise mit derselben Fotomaske die Oxidschicht 13, die zur Ausbildung der Speicherzelle nicht erforderlich ist, nasschemisch entfernt.

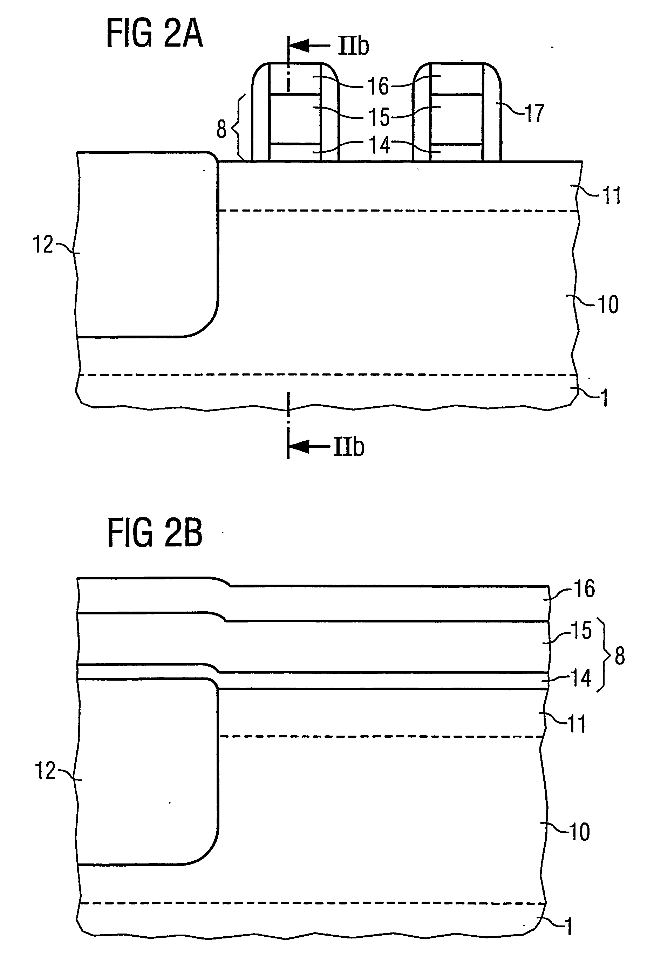

In der Figur 2a ist der in der Figur 1 dargestellte Querschnitt nach dem Aufbringen und Strukturieren einer Schichtfolge mit der streifenförmigen Bitleitung 8 wiedergegeben. Zunächst wird zur Kontaktierung der Source-/Drain-Bereiche eine Polysiliziumschicht 14 des zugehörigen Vorzeichens des Leitfähigkeitstyps aufgebracht, danach eine metallhaltige Schicht 15, beispielsweise Wolframsilicid (WSi), als eigentliche niederohmige Bitleitung und anschließend ein Material einer Hartmaske 16 (z. B. ein Oxid oder Nitrid) zur elektrischen Isolation aufgebracht. Diese Schichten werden dann vorzugsweise durch eine Fototechnik und anisotrope Ätzung streifenförmig strukturiert. Statt des WSi kann eine Schichtfolge aus Wolframnitrid und Wolfram aufgebracht werden. Die elektrisch leitende Schicht kann auch Titan und/oder Titansilicid aufweisen. Die streifenförmigen Bitleitungen 8 werden seitlich durch Spacer 17, vorzugsweise aus einem Oxid oder Nitrid, isoliert.

In der Figur 2b ist der in der Figur 2a bezeichnete Schnitt dargestellt. Es ist dort erkennbar, dass die Bitleitung 8 seitlich über die Randisolation 12 hinaus verlängert ist, so dass sie außerhalb des eigentlichen Speicherzellenfeldes kontaktiert werden kann. Der Ätzprozess zur streifenförmigen Strukturierung der Schichten wird am Rand des Zellenfeldes durch die Randisolation 12 begrenzt. Eventuell zusätzlich zu den Source-/Drain-Bereichen als dotiertes Halbleitermaterial vorhandene vergrabene Anteile der Bitleitungen enden jeweils an der Randisolation 12.

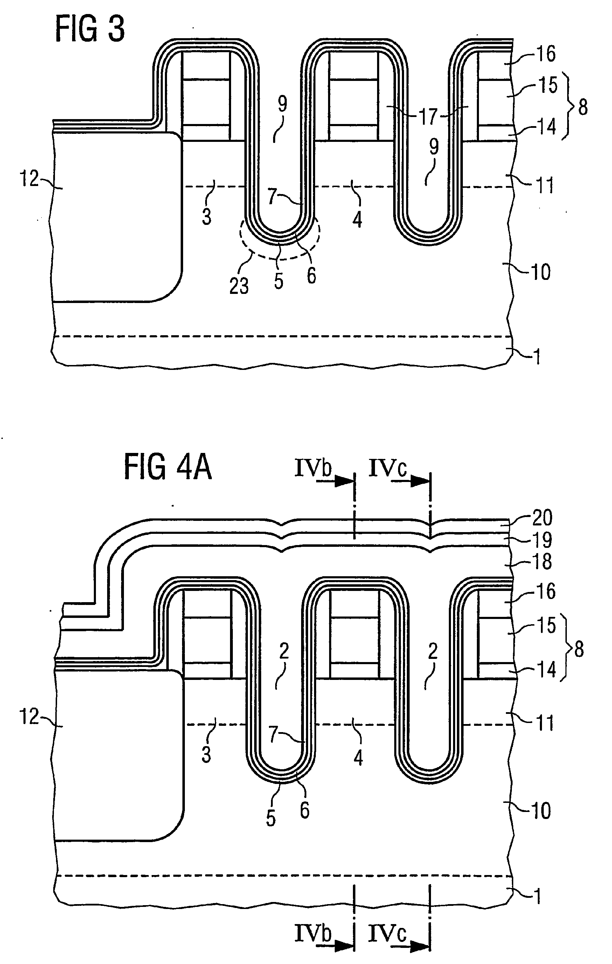

Mit den Bitleitungsstrukturen auf der Oberseite und den oxid- oder nitridbedeckten Bereichen als Maske werden, wie in der Figur 3 dargestellt, selbstjustiert Gräben 9 geätzt (z. B. mittels reactive ion etching, RIE), die für die aktiven Bereiche, insbesondere die einzelnen Speicherzellen, vorgesehen sind. Dazwischen werden die Source-/Drain-Bereiche 3, 4 ausgebildet. Außerdem ist zu berücksichtigen, dass für eine gute Funktionsweise (performance) die jeweils bei einer bestimmten Gate-Spannung vorhandene Ladungsträgerkonzentration in einem an dem Boden des Grabens vorgesehenen Anteil des Kanalbereiches des Speichertransistors ausreichend hoch sein muss; bei einer p-Wanne ist das die Elektronenkonzentration. Bei einer vorteilhaften Ausgestaltung, bei der die Wanne 10 der Speicherzelle eine typische Dotierstoffkonzentration von 10¹⁷ cm⁻³ aufweist, wird deshalb durch eine Implantation in den Boden des Grabens ein dotierter Bereich 23 ausgebildet, der die Dotierstoffkonzentration des Kanalbereiches in der Mitte stärker verändert als in den seitlichen äußeren Bereichen. Dazu wird vorzugsweise zunächst eine Opferschicht aufgebracht (z. B. sacrificial oxide, typisch etwa 6 nm dick, thermisch erzeugt). Dann wird der vorgesehene Dotierstoff implantiert; das ist in dem angegebenen Beispiel einer p-dotierten Wanne Arsen als Dotierstoff mit einer Energie von beispielsweise typisch 20 keV in einer Dosis von 10¹² cm⁻³ bis 10¹⁴ cm⁻³. Die Opferschicht wird entfernt; bei einem Oxid kann das mit verdünnter HF geschehen.

Es wird ganzflächig eine Schichtfolge aus einer unteren Begrenzungsschicht 5, einer Speicherschicht 6 und einer oberen Begrenzungsschicht 7 aufgebracht. Diese Schichtfolge ist als eigentliches Speichermedium vorgesehen und kann wie eingangs beschrieben z. B. eine an sich bekannte ONO-Schichtfolge sein. Dabei kann die untere Begrenzungsschicht 5 beispielsweise ein etwa 2,5 nm bis 8 nm dickes Oxid (bottom oxide, vorzugsweise thermisch erzeugt) sein, die Speicherschicht 6 ein etwa 1 nm bis 5 nm dickes Nitrid (vorzugsweise mittels LPCVD, low pressure chemical vapor deposition, abgeschieden) und die obere Begrenzungsschicht 7 ebenfalls ein Oxid, etwa 3 nm bis 12 nm dick.

Die damit erreichte Struktur ist in der Figur 3 im Querschnitt dargestellt. Mit geeigneter Fototechnik wird das Speicherzellenfeld abgedeckt, so dass im Bereich der Peripherie, die zum Beispiel im Rahmen eines CMOS-Prozesses hergestellt wird, die Speicherschicht einschließlich der Begrenzungsschichten entfernt werden kann. Die Speicherschicht kann auch im Bereich des Speichers auf den Böden der für die Gate-Elektroden vorgesehenen Gräben 9 und/oder zwischen den Gräben 9 entfernt werden, so dass die Speicherschicht zwischen den Wänden eines jeweiligen Grabens und/oder zwischen zwei zueinander benachbarten Gräben unterbrochen ist. Für die Ansteuerperipherie wird das Gateoxid für Hochvolttransistoren und danach eventuell ein dünneres Gateoxid für Niedervolttransistoren aufgewachsen. Mit weiteren Masken und Implantationen können die Einsatzspannungen eingestellt werden.

In dem in der Figur 4a dargestellten Querschnitt ist die Struktur nach dem Abscheiden einer für die Gate-Elektroden 2 vorgesehenen leitend dotierten Polysiliziumschicht 18 sowie einer für die Wortleitung vorgesehenen metallhaltigen Schicht 19 (hier WSi) und einer Hartmaskenschicht 20 dargestellt. Das Polysilizium wird in einer Dicke von typisch 80 nm abgeschieden und vorzugsweise in situ dotiert und ist für die Gate-Elektroden vorgesehen. Die eigentlichen Wortleitungen werden durch das niederohmige, metallische oder metallhaltige Material der metallhaltigen Schicht 19 gebildet. Statt Wolframsilicid kann ein Silicid eines anderen Metalles oder eine mehrlagige metallhaltige Schicht vorhanden sein. Das Material der Hartmaskenschicht 20 ist z. B. ein verdichtetes Oxid.

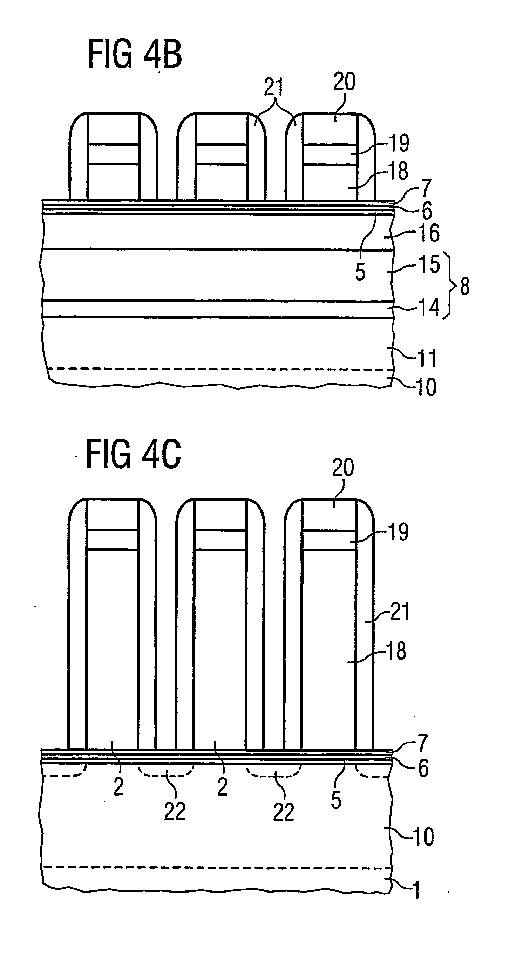

In der Figur 4b und der Figur 4c sind die in der Figur 4a eingezeichneten Schnittansichten dargestellt. In dem Querschnitt der Figur 4b befindet sich die Schichtfolge der Speicherschicht 6 zwischen den Begrenzungsschichten 5, 7 oberhalb der Bitleitung 8, die in diesem Beispiel aus der Polysiliziumschicht 14 und der metallhaltigen Schicht 15 gebildet ist, und davon isoliert durch die Hartmaske 16. In der Figur 4c ist ein Schnitt durch die Gate-Elektroden 2 zwischen zwei Bitleitungen dargestellt, wo die Speicherschicht 6 am Boden der für die Gate-Elektroden vorgesehenen Gräben verläuft. Die aufgebrachte Schichtfolge aus der Polysiliziumschicht 18, der metallhaltigen Schicht 19 und der Hartmaskenschicht 20 wird, wie in den Figuren 4b und 4c zu erkennen ist, streifenförmig strukturiert, so dass quer zu den Bitleitungen verlaufende Wortleitungen ausgebildet werden. Die Flanken der Wortleitungen sind durch Spacer 21 isoliert. Die Spacer werden in der an sich bekannten Weise dadurch ausgebildet, dass eine aus dem Material der Spacer bestehende Schicht isotrop ganzflächig aufgebracht und anisotrop so rückgeätzt wird, dass im Wesentlichen nur die hohen vertikalen Anteile der Spacer 21 an den Flanken der streifenförmig geätzten Wortleitungen stehen bleiben. Die Zwischenräume zwischen den Gate-Elektroden unterhalb der Wortleitungen können statt dessen ganz oder teilweise mit dem Material der Spacer gefüllt bleiben.

In diesem Verfahrensschritt können gleichzeitig die Gate-Elektroden der Transistoren der Ansteuerperipherie strukturiert werden. Im Bereich des Speicherzellenfeldes stoppt die Ätzung der Gate-Elektroden auf der oberen Begrenzungsschicht 7 bzw. der ONO-Schichtfolge. Es kann ergänzend eine Gate-Reoxidation erfolgen und je nach Bedarf eine Anti-Punch-Implantation 22 zur Isolation benachbarter Transistoren eingebracht werden.

Weitere übliche und an sich bekannte Verfahrensschritte zur Herstellung der Transistoren können gleichermaßen vorgesehen werden, wie z. B. LDD-Implantationen (lightly doped drain) und HDD-Implantationen oder eine Abscheidung einer Passivierung aus Nitrid und einer Planarisierung mittels BPSG (Borphosphorsilicatglas) und CMP. Weitere Schritte zur Vervollständigung bestehen in der Herstellung und Füllung von Kontaktlöchern (via holes) sowie der Herstellung von Metallisierungen und Passivierungen. Diese Herstellungsschritte sind von der Herstellung von Speicherbauelementen an sich bekannt.

Bei einer Ausführung der Bitleitungen als streifenförmige Metallisierung auf der Oberseite des Halbleiterkörpers tritt das Problem auf, dass bei der Lithographie zur Herstellung der Gate-Elektroden und der Wortleitungen die Oberseite des Zwischenproduktes uneben ist. Die Höhendifferenz in der Polysiliziumschicht 18 zwischen dem Speicherzellenfeld und der Peripherie ist kritisch für die Lithographie. Wegen der Bitleitungsstege tritt die in der Figur 4a links eingezeichnete Stufe zwischen demjenigen Anteil der Polysiliziumschicht 18, der das Speicherzellenfeld bedeckt, und dem seitlichen Anteil dieser Polysiliziumschicht an der Peripherie des Speicherzellenfeldes auf. Bei den angestrebten zunehmend kleineren Strukturen im Bereich von Maßstäben unterhalb 140 nm ist eine planare Oberfläche vor der Lithographie aber notwendig. Andernfalls bleibt bei der Ätzung das Material der metallhaltigen Schicht 19 (insbesondere Silizid) an der Stufe stehen, so dass alle Wortleitungen kurzgeschlossen sind.

Aufgabe der vorliegenden Erfindung ist es, anzugeben, wie bei einem NROM-Speicherzellenfeld mit Bitleitungsstegen eine Lithographie zur Strukturierung des eingebrachten Gate-Polysiliziums auch bei sehr kleinen Strukturabmessungen möglich ist.

Diese Aufgabe wird mit dem Verfahren mit den Merkmalen des Anspruchs 1 gelöst. Ausgestaltungen ergeben sich aus den abhängigen Ansprüchen.

Bei dem Verfahren werden zunächst die für die Speichertransistoren vorgesehenen Gräben mit dem für die Gate-Elektroden vorgesehenen Polysilizium aufgefüllt. Danach wird die Oberseite planarisiert, was vorzugsweise mittels CMP (Chemical Mechanical Polishing) geschieht. Dieser Planarisierungsschritt stoppt auf der Oberseite der Abdeckschicht, die die Bitleitungsstege nach oben gegen die Wortleitungen isoliert. Diese Abdeckschicht ist vorzugsweise Siliziumnitrid. Danach wird auf die jetzt ebene Oberseite eine Polysiliziumschicht abgeschieden, die für die Wortleitungen vorgesehen ist. Vorzugsweise werden Anteile der für die Bitleitungen aufgebrachten Schichten auch außerhalb des Speicherzellenfeldes angeordnet, so dass eine ganzflächige Planarisierung der Oberseite nach dem Einbringen des Polysiliziums für die Gate-Elektroden erleichtert wird. Die außerhalb des Speicherzellenfeldes vorhandenen Anteile der für die Bitleitungsstege vorgesehenen Schichtfolge werden als Stützstege oder Stützpfeiler verwendet, auf deren Oberseite aus Siliziumnitrid der CMP-Rückschleifschritt stoppt.

Es folgt eine genauere Beschreibung des Verfahrens anhand eines in den Figuren dargestellten Ausführungsbeispiels.

Die Figur 0 zeigt eine schematische Anordnung der Wortleitungen und Bitleitungen in Aufsicht.

Die Figuren 1, 2a, 2b und 3 zeigen Querschnitte durch Zwischenprodukte nach verschiedenen Schritten eines bevorzugten Herstellungsverfahrens.

Die Figuren 4a, 4b und 4c zeigen Querschnitte durch ein Zwischenprodukte nach weiteren Schritten des beschriebenen Herstellungsverfahrens.

Die Figur 5 zeigt einen der Figur 4a entsprechenden Querschnitt durch ein Zwischenprodukt nach weiteren Schritten eines verbesserten Herstellungsverfahrens.

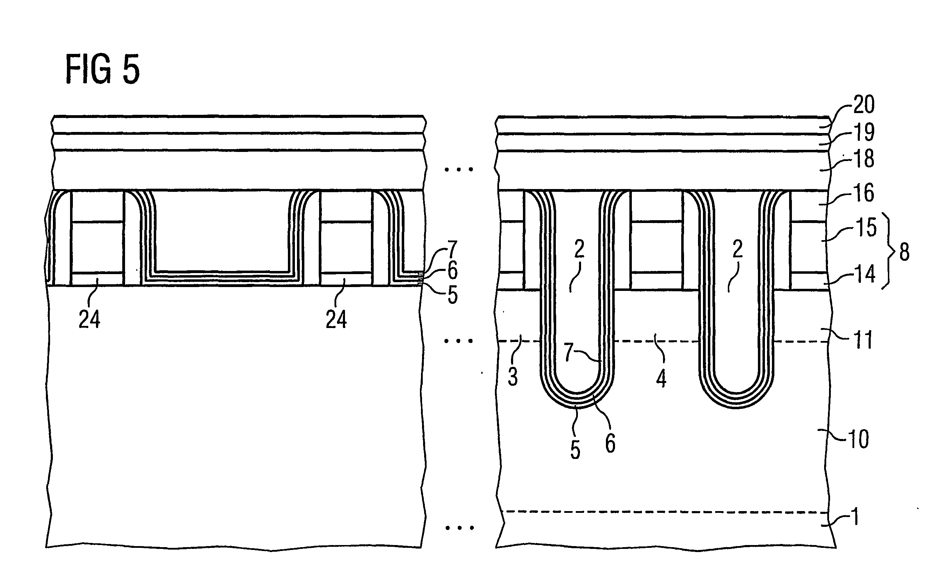

In dem in der Figur 4a dargestellten Querschnitt ist erkennbar, dass die Oberseite der für die Wortleitungen vorgesehenen Polysiliziumschicht 18 bei der herkömmlichen Herstellung nicht eben ist, sondern eine Stufe zur Peripherie hin bildet und zumindest über den in die Gräben eingebrachten Gate-Elektroden 2 gewellt ist. Statt das Polysilizium für die Gate-Elektroden und die Wortleitungen in einem Verfahrensschritt abzuscheiden, wird zunächst entsprechend dem Querschnitt der Figur 5 das Polysilizium für die Gate-Elektroden 2 in die Gräben eingebracht. Anschließend wird das Polysilizium mittels CMP rückgeschliffen, so dass die Oberseite des Bauelementes sich vorzugsweise ganzflächig auf der Höhe der Oberseite der Abdeckschicht (Hartmaske 16) der Bitleitungsstege befindet. Diese Hartmaske ist ein Siliziumoxid oder, vorzugsweise, ein Siliziumnitrid. Die für die Wortleitungen vorgesehene Polysiliziumschicht 18 kann dann auf eine ebene Oberseite aufgebracht werden und ergibt ebenfalls eine ebene Oberseite, auf die dann die nachfolgenden Schichten (in diesem Beispiel die metallhaltige Schicht 19 und die weitere Hartmaskenschicht 20) aufgebracht werden können. Für den nachfolgenden Lithographieschritt zur Strukturierung der Gate-Elektroden und der Wortleitungen ist so eine ausreichend ebene Oberseite vorhanden.

In der Figur 5 ist auf der linken Seite ein Bereich des Bauelementes außerhalb des Speicherzellenfeldes dargestellt. In einem bevorzugten Ausführungsbeispiel werden in diesem Bereich Stützstrukturen 24 vorgesehen, die z. B. Stege oder Pfeiler sein können und die vorzugsweise aus Anteilen der für die Bitleitungsstege aufgebrachten Schichten gebildet werden. Die Stützstrukturen 24 dienen dazu, ganzflächig eine ebene Oberseite der Polysiliziumschicht 18 zu erreichen. Die Stützstrukturen 24 werden vorzugsweise hergestellt, indem bei der Strukturierung der Bitleitungen 8 die dafür vorgesehene Schichtfolge (hier die Polysiliziumschicht 14, die metallhaltige Schicht 15 und die Hartmaske 16) außerhalb des Speicherzellenfeldes nicht vollständig entfernt wird, sondern in der dargestellten Weise zu den Stützstrukturen 24 strukturiert wird. Die Schichtfolge aus der Begrenzungsschicht 5, der Speicherschicht 6 und der Begrenzungsschicht 7 ist in der Figur 5 auch im Bereich der Stützstrukturen 24 eingezeichnet. Diese Schichtfolge kann jedoch durch eine geeignete Maskierung auf das Speicherzellenfeld begrenzt bleiben, da sie für die Stützstrukturen 24 nicht notwendig ist.

Die Anordnung und Form der Stützstrukturen 24 kann dabei weitgehend den Erfordernissen des Prozessschrittes der Planarisierung und der Anordnung der außerhalb des Speicherzellenfeldes vorhandenen Schaltungskomponenten angepasst werden. Dabei sind insbesondere die Anordnung der Komponenten der Ansteuerperipherie sowie die Größe der zu planarisierenden Oberfläche zu berücksichtigen.

### Bezugszeichenliste

- 1: Halbleiterkörper
- 2: Gate-Elektrode
- 3: Source-/Drain-Bereich
- 4: Source-/Drain-Bereich
- 5: Begrenzungsschicht
- 6: Speicherschicht
- 7: Begrenzungsschicht
- 8: Bitleitung
- 9: Graben
- 10: p-Wanne
- 11: dotierter Bereich
- 12: Randisolation
- 13: Oxidschicht
- 14: Polysiliziumschicht
- 15: metallhaltige Schicht
- 16: Hartmaske
- 17: Spacer
- 18: Polysiliziumschicht
- 19: metallhaltige Schicht
- 20: Hartmaskenschicht
- 21: Spacer
- 22: Anti-Punch-Implantation
- 23: Anteil des Kanalbereiches
- 24: Stützstrukturen

## Patentansprüche

1. Verfahren zur Herstellung eines NROM-Speicherzellenfeldes, bei dem
an einer Oberseite eines Halbleiterkörpers (1) oder einer Halbleiterschicht Dotierstoff zur Ausbildung von Source-/Drain-Bereichen (3, 4) eingebracht wird, parallel im Abstand zueinander angeordnete Gräben (9) in das Halbleitermaterial geätzt werden und zwischen diesen Gräben (9) auf der Oberseite des Halbleiterkörpers (1) oder der Halbleiterschicht jeweils eine parallel zu den Gräben (9) verlaufende Bitleitung (8) angeordnet wird, die mit den zwischen den betreffenden Gräben (9) vorhandenen Souirce-/Drain-Bereichen (3, 4) elektrisch leitend verbunden ist und oberseitig mit einer Abdeckschicht (16/17) zur elektrischen Isolation versehen wird, zumindest an den Wänden der Gräben (9) eine Speicherschicht (5, 6, 7) aufgebracht wird, in vorgesehenen Abständen Gate-Elektroden (2) in den Gräben angeordnet werden und diese Gate-Elektroden (2) mit quer zu der Richtung der Bitleitungen (8) verlaufend aufgebrachten Wortleitungen (18/19) elektrisch leitend verbunden werden,
**dadurch gekennzeichnet, dass**
mit den Bitleitungen (8) außerhalb des Speicherzellenfeldes Stützstrukturen (24) strukturiert werden,
nach dem Einbringen von Polysilizium, das für die Gate-Elektroden (2) vorgesehen ist; in die Gräben (9) die Oberseite planarisierend rückgeschliffen wird, bis die Oberseite der Abdeckschicht (16) erreicht ist, wobei die Stützstrukturen (24) zur Unterstützung der Planarisierung des Polysiliziums außerhalb des Speicherzellenfeldes vorgesehen sind, und danach ganzflächig eine Polysiliziumschicht (18), die für die Wortleitungen vorgesehen ist, aufgebracht und zu den Wortleitungen strukturiert wird.

2. Verfahren nach Anspruch 1, bei dem
das Rückschleifen mittels CMP ausgeführt wird.

3. Verfahren nach Anspruch 1 oder 2, bei dem
als Abdeckschicht (16/17) Nitrid oder Oxid auf die Bitleitungen (8) aufgebracht wird und diese Abdeckschicht als Stoppschicht beim Rückschleifen des Polysiliziums verwendet wird.

## Claims

1. Method for fabricating an NROM memory cell array, in which,
at a top side of a semiconductor body (1) or of a semiconductor layer, dopant is introduced in order to form source/drain regions (3, 4), trenches (9) arranged parallel at a distance from one another are etched into the semiconductor material and a bit line (8) running parallel to the trenches (9) is in each case arranged between said trenches (9) on the top side of the semiconductor body (1) or of the semiconductor layer, which bit line is electrically conductively connected to the source/drain regions (3, 4) present between the relevant trenches (9) and, on the top side, is provided with a covering layer (16/17) for electrical insulation, a storage layer (5, 6, 7) is applied at least at the walls of the trenches (9), gate electrodes (2) are arranged in the trenches at predetermined distances and said gate electrodes (2) are electrically conductively connected to word lines (18/19) applied in a manner such that they run transversely with respect to the direction of the bit lines (8),
**characterized in that**
supporting structures (24) are patterned with the bit lines (8) outside the memory cell array,
after the introduction of polysilicon, which is provided for the gate electrodes (2), into the trenches (9), the top side is ground back in a planarizing manner until the top side of the covering layer (16) is reached, the supporting structures (24) being provided for supporting the planarization of the polysilicon outside the memory cell array, and
afterwards a polysilicon layer (18), which is provided for the word lines, is applied over the whole area and patterned to form the word lines.

2. Method according to Claim 1, in which
the grinding back is performed by means of CMP.

3. Method according to Claim 1 or 2, in which,
as covering layer (16/17), nitride or oxide is applied to the bit lines (8) and this covering layer is used as a stop layer during the grinding back of the polysilicon.

## Revendications

1. Procédé de production d'un champ de cellules de mémoire NROM, dans lequel
on introduit sur une face supérieure d'un corps (1) semi-conducteur ou d'une couche semi-conductrice de la substance de dopage pour former des zones (3, 4) de source/drain, on ménage par attaque dans le matériau semi-conducteur des sillons (9) disposés parallèlement à distance les uns des autres et on dispose entre ces sillons (9) sur la face supérieure du corps (1) semi-conducteur ou de la couche semi-conductrice, respectivement, une ligne (8) de bits qui s'étend parallèlement aux sillons (9), qui est reliée de manière conductrice de l'électricité aux zones (3, 4) de source/drain présentes entre les sillons (9) concernés et qui est munie du côté supérieur d'une couche (16, 17) de recouvrement pour l'isolement électrique, une couche (5, 6, 7) de mémorisation étant déposée au moins sur les parois des sillons (9), des électrodes (2) de grille étant disposées dans les sillons à des intervalles prévus et ces électrodes (2) de grille étant reliées d'une manière conductrice de l'électricité à des lignes (18/19) de mots déposées en s'étendant transversalement à la direction des lignes (8) de bits,
**caractérisé en ce que**
on structure avec les lignes (8) de bits à l'extérieur du champ de cellules de mémoire des structures (24) d'appui ;
après l'introduction du polysilicium prévu pour les électrodes (2) de grille, on effectue dans les sillons (9) un polissage en retour de planarisation de la face supérieure jusqu'à atteindre la face supérieure de la couche (16) de recouvrement, les structures (24) d'appui étant prévues pour favoriser la planarisation du polysilicium à l'extérieur du champ de cellules de mémoire ; et
ensuite, on dépose sur toute la surface une couche (18) de polysilicium prévue pour les lignes de mots et on la structure en les lignes de mots.

2. Procédé suivant la revendication 1, dans lequel on effectue le polissage en retour au moyen d'un CMP.

3. Procédé suivant la revendication 1 ou 2, dans lequel on dépose comme couche (16/17) de recouvrement du nitrure ou de l'oxyde sur les lignes (8) de bits et l'on utilise cette couche de recouvrement comme couche d'arrêt lors du polissage en retour du polysilicium.
